# DEMANDE DE BREVET EUROPEEN

(11) **EP 0 533 575 A1**
(43) Date de publication de la demande: **24.03.1993**
(21) Numéro de dépôt: 92402561.2
(22) Date de dépôt: 17.09.1992
(51) Int. Cl.: C23C 28/02, C23C 14/20, C23C 14/04, H01M 4/84

(54) **Feuillards métalliques supportés sur plastique obtenu par métallisation-placage**

(30) Priorité: 17.09.1991 CA 2051604
(71) Demandeur: HYDRO-QUEBEC, Montréal Québec H2Z 1A4 (CA)
(72) Inventeur: St-Amant, Guy, Trois-Rivières-Ouest, Québec G8Y 6N7 (CA); Carignan, Claude, Québec G9P 4K7 (CA)
(74) Mandataire: Schrimpf, Robert

(57) **Abrégé**

Métallisation sous vide, d'au moins une face d'un film plastique de façon à obtenir un substrat comportant une surface métallique, lequel substrat est suffisamment conducteur de l'électricité pour permettre un dépôt électrochimique uniforme. Ce dernier est effectué par un placage électrochimique, d'au moins un métal sur la surface métallisée à partir d'une solution électrolytique, de façon à obtenir un film métallique mince ayant une épaisseur de métal comprise entre 0,1 et 4 microns. Le substrat métallisé est choisi de façon à être compatible et à faciliter l'étape de placage électrochimique. Le feuillard métallique mince obtenu est adhérent et supporté sur le film plastique. Le feuillard métallique peut être utilisé comme collecteurs de courant pour batteries au lithium à électrolyte polymère, comme film multicouche utilisé comme matériau d'emballage perméable aux gaz et à l'humidité, comme écran pour la lumière, conducteurs flexibles, etc.

## Description

L'invention concerne un procédé de fabrication d'un feuillard métallique supporté sur plastique, obtenu par métallisation-placage, ainsi que le feuillard métallique résultant de ce procédé. Plus précisément l'invention se rapporte à un procédé de préparation de films métalliques constitués d'au moins un métal déposé par métallisation sur un film plastique non-conducteur, le tout recouvert d'un autre métal par placage électrochimique, ces films métalliques ayant une épaisseur dans la gamme de 0,1 à 4 microns.

La fabrication de films métalliques minces se heurte à des difficultés lorsque les épaisseurs mises en oeuvre sont de l'ordre du micron. Ces difficultés entraînent des coûts élevés et ne laissent qu'un choix limité de métaux à mettre en oeuvre. Les trois principales méthodes industrielles actuellement utilisées sont le laminage, l'électroformage sur mandrin et la métallisation. Les épaisseurs minimum obtenues par les deux premières méthodes sont de l'ordre de 5 à 20 microns et le film produit est libre. La métallisation doit être faite sur un support plastique et l'épaisseur normalement obtenu sur plastique ne dépasse guère 0,1 micron.

Parmi les procédés industriels présentement disponibles pour fabriquer des films minces de moins de 15 microns, le laminage est le plus couramment utilisé. Ce dernier consiste à réduire l'épaisseur de la tôle en la faisant passer entre deux rouleaux sur lesquelles une pression est appliquée. Toutefois peu de métaux sont laminés à ces épaisseurs (par exemple: Au, Al, Pb, laiton, acier inoxydable) et, de façon générale, les coûts augmentent rapidement et la capacité des procédés diminue radicalement pour des épaisseurs en-dessous de 50 à 5 microns, en vertu du nombre de passes requises par le laminage, de la difficulté de manipuler des films ayant une faible résistance mécanique, de l'apparition de perforations en cours de procédés, ainsi que des problèmes de recuits et de la contamination par les lubrifiants. De plus, les épaisseurs minimum commercialement disponibles (12 microns pour l'acier inoxydable, 6-7 microns pour l'aluminium) sont encore excessives et pénalisantes en coût, en matière, en poids ou volume mort pour plusieurs applications. Le produit final obtenu par laminage est une bobine d'un feuillard métallique rectangulaire.

L'électroformage est une technique de placage où le film métallique libre et autosupporté est obtenu par dépôt électrochimique, à partir d'une solution électrolytique, sur un mandrin conducteur électronique. Les coûts de fabrication sont élevés (environ 1$ US/pi² pour le nickel) et les épaisseurs minimales disponibles sont de 6 microns pour le nickel et de 10 microns pour le cuivre. Cette technique est applicable à certains matériaux seulement et, la nécessité de manipuler et de peler un film libre après le dépôt, impose des épaisseurs minimum sous peine de ne plus être en mesure de peler le film du mandrin sans risquer d'abîmer le film. Les films de cuivre électroformés sont produits en grande quantité et utilisés principalement pour la fabrication de circuits imprimés. Le produit final obtenu par électroformage de feuillard métallique est une bobine d'un feuillard rectangulaire.

La métallisation ou déposition sous vide consiste à évaporer un métal pour qu'il se dépose sur un support. Les procédés les plus courants sont: la métallisation par vaporisation et les vaporisations assistées telles que la pulvérisation cathodique et par faisceau d'électrons. Le procédé de vaporisation est le plus utilisé, il consiste à chauffer le métal de façon à ce que sa pression de vapeur soit significativement supérieure à la pression dans la chambre à vide. La quantité de métal qu'il est possible d'évaporer est fonction de la température utilisée (1200°C pour l'Al et le Cu) et de la surface du bain. Les épaisseurs maximum déposées sont fonction du procédé et de la résistance à la chaleur du substrat. Les épaisseurs des métallisations sur plastiques dépassent rarement 0,5 micron et sont généralement de l'ordre de 0,01 micron. L'épaisseur de la métallisation est limitée entre autre par la surchauffe du plastique. Les dépôts obtenus sur plastique sont utilisés couramment dans des applications où l'épaisseur métallisée ne requiert pas des dépôts épais, i.e., < 0,1 micron, tel que les métallisations décoratives, les barrières à la diffusion des gaz, les collecteurs de courant de condensateurs plastiques, les revêtements partiellement réfléchissants, etc. Ces métallisations sont fragiles et, à cause de leur faible épaisseur, elles sont également peu conductrices de l'électricité, généralement de l'ordre de 0,5 à > 100 ohm / carré.

Le placage sur plastique est utilisé, entre autre, dans l'industrie automobile. Le procédé est utilisé dans 85% des cas pour plaquer des pièces moulées en ABS. les principales étapes nécessaires avant d'effectuer le placage sont: nettoyage dans une solution alcaline, rinçage, oxydation de la surface à l'aide d'une solution à base d'acide chromique, neutralisation pour éliminer le chrome hexavalent, rinçage, bain de catalyse à base d'étain et de palladium, accélérateur pour enlever l'étain et exposer le palladium, rinçage, glacage autocatalytique au nickel ou au cuivre. Après ces étapes les pièces sont recouvertes d'environ 0,12 à 0,75 micron de cuivre et peuvent recevoir d'autre placage.

Les épaisseurs préconisées selon la présente invention ne sont pas accessibles au laminage et la métallisation sous vide permet au plus avec certains plastiques résistant à la chaleur d'atteindre les valeurs inférieures de la gamme prévu par l'invention et ce, au prix d'un ralentissement considérable du procédé.

Contrairement à l'invention, le procédé de placage sur plastique utilisé dans l'art antérieur implique l'utilisation d'un plastique spécifique et de nombreux traitements chimiques. Le procédé de placage sur plastique nécessite des installations de contrôle de la pollution, en raison de l'utilisation de métaux comme le chrome hexavalent. Le précurseur au placage pour le procédé de placage sur plastique est mat à cause de la nature du procédé par lequel on oxyde le plastique et on induit des sites catalyseurs pour le dépôt autocatalytique.

L'invention vise à un procédé selon lequel l'état de surface du précurseur métallique qui est déposé sous vide épouse parfaitement la surface de plastique, ce qui permet d'obtenir la surface désiré.

Un autre objet de l'invention est de permettre de ne traiter qu'une face du film plastique lorsque cela est souhaitable, alors que dans le placage sur plastique de l'art antérieur toutes les surfaces de la pièce sont traitées.

Un autre objet de l'invention est de permettre une opération très régulière assurant un contrôle très précis des épaisseurs, ceci étant beaucoup plus difficile avec le placage sur plastique à cause du nombre d'étapes et la notion de sites d'activation.

Un autre objet de l'invention réside en un procédé plus simple que le placage sur plastique à cause du nombre limité d'opérations à effectuer.

Un autre objet de l'invention consiste à effectuer le placage du métal selon deux méthodes: le placage avec courant imposé et le placage autocatalytique. Le placage avec courant imposé permet des vitesses de placage beaucoup plus rapide et la pureté du métal déposé est meilleure qu'avec le placage autocatalytique.

Un autre objet de l'invention réside en l'usage d'une surface conductrice obtenue par métallisation sous vide, laquelle est très favorable à un dépôt métallique rapide, uniforme et chimiquement propre. Aucun nettoyage de la surface métallisée n'est nécessaire avant placage.

Un autre objet de l'invention consiste en la production de feuillards ayant une structure métallique composite; cette possibilité permet d'optimiser les propriétés du produit.

Un autre objet de l'invention est de choisir le dernier métal plaqué en fonction de sa résistance à la corrosion, de sa soudabilité, de sa compatibilité avec une colle etc. Le ou les métaux sous-jacents sont choisis en fonction de leurs conductivités, leurs propriétés mécaniques ou électriques, etc.

Un autre objet de l'invention est de contrôler la géométrie et la conductivité de surface des zones électrodéposées grâce à l'utilisation de techniques bien connues en galvanoplastie; cette possibilité présente un avantage vis-à-vis le laminage. Cet avantage peut être utilisé pour optimiser l'utilisation des matériaux.

Un autre objet de l'invention est de faciliter la manipulation dans des machines automatiques des feuillards métalliques réalisés, et grâce à l'utilisation d'un support plastique.

Un autre objet de l'invention est de permettre également de contrôler la surface, l'épaisseur et la forme des parties où sera effectué le dépôt électrochimique.

Un autre objet de l'invention est de permettre d'obtenir sur un même support des zones isolantes, des zones métallisées, et des zones ayant un dépôt électrochimique d'au moins un métal ce qui est impossible pour les procédés de laminage, de métallisation et de placage.

Un autre objet de l'invention est de permettre en outre et de façon optionnelle, la manipulation aisée puis le pelage des revêtements métalliques par transfert d'adhésifs par un contrôle approprié de l'adhésion entre le support plastique et le premier dépôt obtenu par métallisation sous vide.

Un autre objet de l'invention réside dans l'utilisation de feuillards métalliques pour la fabrication d'éléments chauffants, de revêtements métalliques minces pour absorber ou réfléchir la lumière et/ou la chaleur, de barrières métalliques pour bloquer la diffusion des gaz dans les emballages multicouches et de collecteurs de courant, notamment dans les batteries en films minces.

Un autre objet de l'invention est d'utiliser un feuillard métallique à titre de collecteur de courant des électrodes d'un générateur électrochimique en film mince.

L'invention concerne un procédé de préparation de films métalliques constitués d'au moins un métal supporté par un film non-conducteur en résine synthétique comprenant les étapes suivantes:
- métallisation sous vide, d'au moins une face du film plastique de façon à obtenir un substrat comportant une surface métallique, ledit substrat étant suffisamment conducteur de l'électricité pour permettre un dépôt électrochimique uniforme,
- dépôt par placage électrochimique, d'au moins un métal sur la surface métallisée à partir d'une solution électrolytique, de façon à obtenir un film métallique mince ayant une épaisseur de métal comprise entre 0,1 et 4 micron, le substrat métallisé étant choisi de façon à être compatible et à faciliter l'étape de placage électrochimique, le film métallique mince obtenu étant supporté par ledit film plastique. La métallisation et le dépôt par placage électrochimique peuvent s'effectuer en continu.

Le procédé de métallisation sous vide est choisi de préférence parmi les procédés de vaporisation thermochimique simple, ou assistée.

Quant à la vaporisation thermochimique assistée, elle s'effectue de préférence par pulvérisation cathodique ou à faisceau d'électrons.

Selon une réalisation alternative, on contrôle la surface métallisée par des procédés de cache ou de démétallisation, notamment par faisceau laser, dissolution chimique, arrachement chimique ou étincelage.

Le film plastique non-conducteur isolant est de préférence en une résine synthétique choisie pour sa compatibilité avec le vide et les solutions associées avec les procédés de galvanoplastie, notamment un polypropylène, un polyester, un polysulphone un polyéthylène, ou un polyimide.

Le substrat comportant une surface métallisée est de préférence constitué d'éléments compatibles avec le dépôt par placage électrochimique, choisi parmi les métaux suivants: Cu, Au, Ag, Fe, Ni, Cr, Zn, Mo ou leurs alliages, particulièrement Cu, Au, Ag ou leurs alliages, dont la résistance de surface varie notamment entre 0,1 et 10 ohm/carré.

Selon une autre réalisation de l'invention, la métallisation sous vide s'effectue de façon en ce que la surface métallisée ne couvre que partiellement la surface du film support isolant de façon à laisser des zones non-conductrices. Un recouvrement partiel de la surface du film par métallisation du film support isolant avant l'étape de dépôt électrochimique, peut s'obtenir par l'utilisation de masques lors de la métallisation, par l'ablation du dépôt métallisé, notamment par traitement au laser, par étincelage, par voie chimique ou mécanique.

Il est aussi possible que la surface métallisée soit recouverte de masques isolants pour empêcher le placage localement, lesquels masques seront, le cas échéant, enlevés par la suite. Le métal déposé par placage est par exemple compris parmi les éléments suivants: Ni, fe, Au, Ag ou leurs alliages. De préférence la métallisation s'effectue avec du cuivre et le métal du dépôt par placage comprend du nickel. Le métal déposé par placage est par exemple compris parmi les éléments suivants: Ni, Fe, Mo, Au, Ag, Cr, Zn, Pb, Cd ou leurs alliages.

La solution électrolytique de placage type autocatalytique permet l'utilisation d'une métallisation plus mince, que lorsqu'on utilise une solution électrolytique ordinaire. On peut recouvrir le feuillard métallique d'un film plastique, notamment par laminage ou collage.

Selon une autre réalisation de l'invention, on transfère le feuillard métallique en tout ou en partie, du support plastique vers une autre surface ayant une adhésion par rapport au dernier métal plaqué supérieur à celle entre la métallisation et le support plastique. On peut aussi traiter le feuillard métallique chimiquement pour lui donner une faible émissivité dans l'ultraviolet.

Les feuillards métalliques selon l'invention peuvent être utilisés pour constituer des éléments chauffants qui peuvent être intégrés dans un ensemble flexible ou rigide, des collecteurs de courant pour les batteries, notamment au lithium à électrolyte polymère, des empaquetages avec une perméabilité très faible, des écrans pour la lumière, des conducteurs flexibles, etc.

La capacité des métaux de bloquer, de réfléchir, ou d'absorber les radiations et rayonnements est bien connue. Dans certains cas l'utilisation d'un film métallique flexible est très désirable. Le produit selon l'invention combine pour une multitude d'applications les avantages du film plastique pour la manipulation, et de la surface métallique pour l'opacité. Le film peut être utilisé dans les différents type de store pour bloquer la lumière.

Une modification de la surface du feuillard de nickel peut, par exemple, permettre une faible émissivité des rayons ultraviolet. L'utilisation d'une épaisseur de nickel minimale permet de conserver une excellente flexibilité si on la compare au produit électroformé. On peut utiliser ce produit pour éviter la détection par des systèmes de vision de nuit. Il est aussi possible d'enduire d'adhésif l'endos du film de support pour permettre de recouvrir les surfaces à protéger.

La capacité de réfléchir les radiations peut être utilisée pour l'utilisation de coupe vapeur. On combine alors la facilité d'utilisation du plastique avec l'imperméabilité au gaz, la réflectivité et la résistance à la corrosion du revêtement métallique comme le nickel. Le coupe vapeur est donc plus efficace du point de vue énergétique, de la longévité, et de la perméabilité.

La résistance électrique du film métallique sur plastique permet son utilisation comme résistance pour produire de la chaleur. On peut utiliser cette résistance dans les plafonds pour le chauffage par rayonnement ou comme élément chauffant à grande surface pour chauffer les liquides; la grande surface de chauffe évite la formation de points chauds qui pourraient détériorer le contenu du réservoir.

Il est préférable de choisir le support plastique en fonction de l'adhésion désirée entre la métallisation et ledit support. Pour augmenter l'adhésion on peut traiter la surface à métalliser par effet couronne.

La métallisation s'effectue normalement sous vide en utilisant un métal favorable au dépôt électrochimique ultérieur de façon à induire une résistance électrique suffisante pour permettre le passage du courant de placage (préférablement inférieure à 10 ohm/carré). Si la résistance électrique est trop forte, on doit limiter le courant de placage à cause du danger de surchauffe, ce qui diminue d'autant la vitesse maximum de placage. Il est possible, par l'utilisation de masques, d'obtenir des surfaces non métallisée sur le support plastique, par exemple, pour l'obtention d'une bordure non métallisée sur la longueur du film.

On peut recouvrir au recouvrement local de la métallisation pour conserver des zones métallisées non plaquées. Ces zones moins conductrices peuvent servir de fusibles, d'éléments chauffants, ou être dissoutes ultérieurement.

La démétallisation locale peut s'effectuer par ablation avec faisceau laser, dissolution chimique, arrachement mécanique ou étincelage, lorsque, pour certaines applications, l'utilisation de masques au niveau de la métallisation s'avère difficilement réalisable.

Le dépôt électrochimique sur le film métallisé se fait avec au moins un métal sur les surfaces rendues conductrices par la métallisation jusqu'à l'obtention d'un dépôt d'épaisseur comprise entre environ 0,02 et 4 microns. Les conditions requises lors du dépôt électrochimique sont bien connues de l'homme de l'art et portent sur la solution électrolytique, la disposition des électrodes, les densités de courant employées qui permettent d'optimiser la densité, la conductivité et l'état de surface du dépôt électrochimique. La vitesse de placage possible avec ce procédé, et cela sans optimisation peut atteindre 2 m/min lorsqu'une épaisseur de 0,3 micron de nickel est déposée. Bien entendu, au cours de cette étape, il est possible de contrôler le fini de surface, l'épaisseur et la résistivité du ou des dépôts électrochimiques successifs, et ce en jouant sur les paramètres connus des dispositifs de placage électrochimique (densité de courant, additifs, cache, distance des électrodes,etc.).

La démétallisation du dépôt placage et/ou de la métallisation peut être effectuée par ablation par faisceau laser, arrachement mécanique ou étincelage lorsque la démétallisation est plus pratique que l'utilisation d'un jeu de masques. L'enlèvement des masques placés précédemment peut être effectué par tout moyen connu.

Les caractéristiques et avantages de l'invention ressortiront mieux à l'aide des exemples qui suivent ainsi que des dessins annexés illustrant des modes de réalisations non limitatifs. Dans les dessins,
la figure 1 est une vue en plan d'un feuillard métallique sur support plastique selon l'invention avec bordure non métallisée et non plaquée;
la figure 2 est une vue en coupe selon 2-2 de la figure 1;
la figure 3 est une représentation schématique de l'étape de placage sur plastique métallisé dans le cas où une seule face du support est plaquée;
la figure 4 est une représentation schématique d'un panneau de chauffage par résistance;
la figure 5 est une vue en coupe selon 5-5 de la figure 4;
la figure 6 est une vue similaire à la figure 4, comportant une zone démétallisée au laser;
la figure 7 est une vue en coupe selon 7-7 de la figure 6;
la figure 8 est une représentation schématique, en plan, d'un revêtement à faible émissivité dans l'ultraviolet;
la figure 9 est une vue en coupe selon 9-9 de la figure 8;
la figure 10 est une illustration schématique d'une méthode pour obtenir une gradation de l'épaisseur du placage;
la figure 11 est une vue en coupe d'un feuillard métallique selon l'invention que l'on peut utiliser comme collecteur de courant selon l'invention; et
la figure 12 est une vue en plan représentant un grand nombre de bandes de feuillard métallique supporté sur plastique et reliées en parallèle.

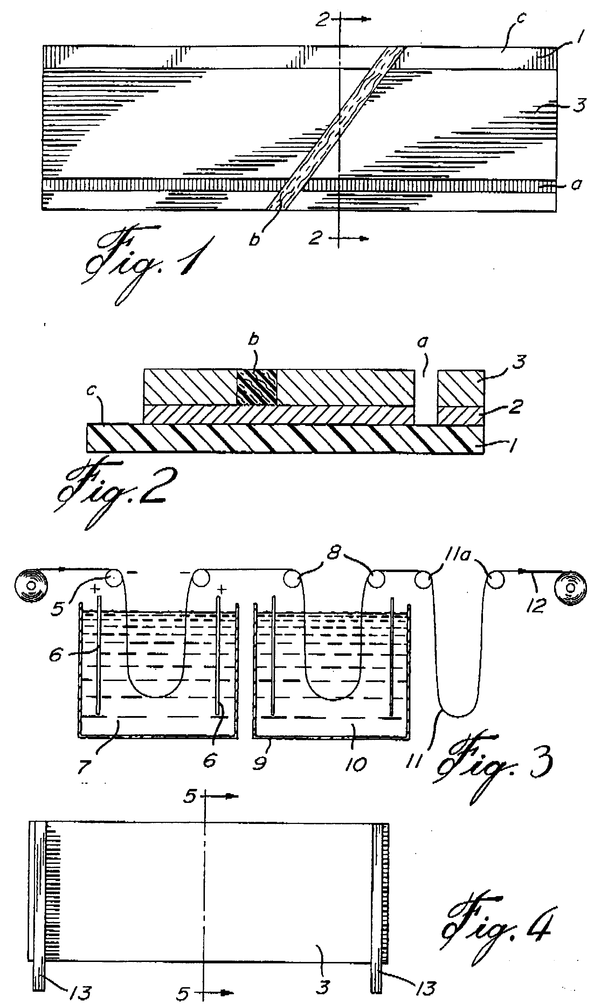

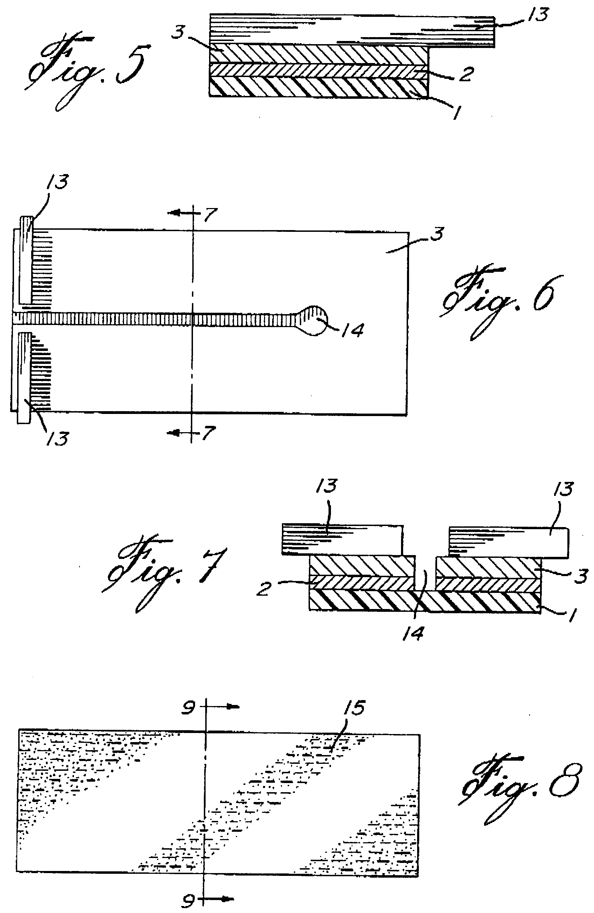

En se référant aux figures 1 et 2, on notera que le support plastique 1 est à titre d'exemple en polypropylène 23 microns et que ce dernier fut traité en surface par effet couronne afin d'obtenir une meilleure adhésion du métal 2 déposé par métallisation; dans le présent cas du cuivre, dont la conductivité de surface est de 0,5 Ω/ carré. On observe d'autre part un dépôt de nickel 3 de 0,3 micron d'épaisseur, obtenu par déposition électrochimique. On retrouve en a une zone démétallisée au laser et en b une zone transversale recouverte d'isolant.

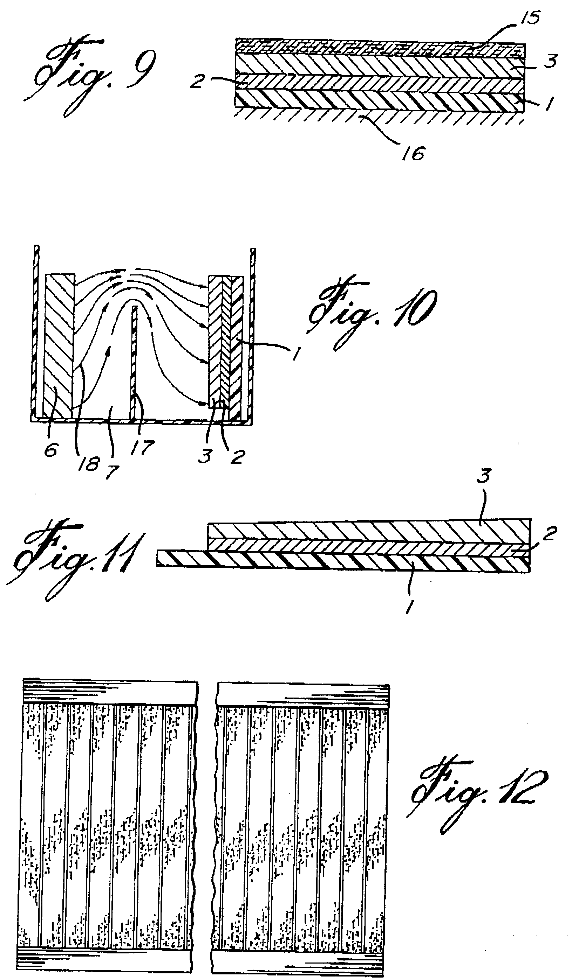

La figure 3 utilise un rouleau de film métallisé 4 obtenu par métallisation sous vide. Le film métallisé 4 circule autour de prises de contact électrique 5 avec la surface métallisée, reliées à des électrodes de nickel 6 par l'entremise d'une solution électrochimique de placage 7. A la sortie de la solution de placage 7, le rouleau de film plaqué en 7 circule autour des rouleaux 8 dans une cuve 9 comportant une solution de rinçage 10. Le rouleau circule ensuite dans une section de séchage 11 autour de rouleaux 11a après quoi le feuillard métallique supporté obtenu par placage en 7 est enroulé en 12.

Les figures 4, 5, 6 et 7 montrent un conducteur 13 fixé au feuillard métallique et servant de distributeur de courant. Aux figures 6 et 7 on retrouve une zone démétallisée 14.

Les figures 8 et 9 illustrent un revêtement MAXORB^{mc} 15 développé par INCO permettant au dépôt de nickel d'avoir une faible émissivité des rayons ultraviolet.

Dans la figure 10 on voit qu'il est possible d'obtenir une gradation dans l'épaisseur du placage. Pour ce faire, il s'agit de placer un isolant 17 dans la solution électrolytique de placage pour dévier les lignes de courant.

Les exemples qui suivent illustrent l'invention sans la limiter.

### EXEMPLE 1

Cet exemple illustre le procédé de production en deux étapes continues d'un film de nickel de 0,3 micron d'épaisseur supporté sur polypropylène. Dans cet exemple, la métallisation de cuivre sur polypropylène est obtenue en continu par évaporation sous vide de cuivre sur une des faces du film plastique préalablement traité par effet couronne. Les procédés de métallisation de métaux tels que Al, Zn, Au sont bien connus des spécialistes; le choix du cuivre, moins documenté, est fait parce que ce métal est particulièrement favorable au dépôt électrochimique du nickel. Le cuivre est plus économique que l'or tandis que le zinc et l'aluminium en couche très mince sont extrêmement difficile à plaquer de façon satisfaisante. La conductivité de surface du dépôt métallisée est de 0,5 ohm/carré. Une cache est utilisée pour obtenir une bordure non métallisée.

Le film métallisé est utilisé tel quel pour la seconde étape qui consiste en un dépôt électrochimique de nickel dans un dispositif tel qu'illustré à la figure 3. La solution de placage est une solution du type sulfamate de nickel normalement utilisée pour l'obtention de dépôt ayant de faibles contraintes mécaniques internes. Les densités de courant utilisées lors du placage sont de 0,05 à 0,3 A/cm2 et les vitesses de déroulement obtenues, sans optimisation du procédé, sont d'environ 2 m/min pour un dépôt de 0,3 micron de nickel. Le film est par la suite lavé et séché par des procédés conventionnels. Le feuillard obtenu est illustré aux figures 1 et 2. Dans ces figures on montre une zone n'ayant pas été métallisée qui n'est donc pas plaquée c, une zone a recouverte d'un masque (vernis) qui n'a pas non plus reçu de placage, et une zone démétallisée a mécaniquement pour empêcher le placage. Dans cet exemple, la démétallisation en a a été réalisée à l'aide d'un laser à impulsion. L'épaisseur du film de nickel obtenu est de 0,3 micron et sa conductivité de surface est de 0,15 ohm/carré.

Le placage dans les épaisseurs de l'ordre de 0,3 micron possède une excellente flexibilité. On peut donc effectuer plusieurs plis sur un rayon de 2 mm sans problème. Le placage possède une bonne cohérence sur son substrat, l'adhésion du nickel sur le cuivre est meilleure que celle du cuivre sur le polypropylène. L'aspect du dépôt est brillant pour des dépôts inférieurs à environ 0,5 micron. Plus les dépôts sont épais, plus on se rapproche du fini mât caractéristique du placage à l'aide d'un bain de sulfamate de nickel. Il est bien entendu que ce fini peut se modifier facilement par modification de la composition de la solution.

### EXEMPLE 2

Procédé semblable à l'exemple 1 dans lequel l'épaisseur de nickel est augmentée pour permettre une attaque chimique de sa surface. Dans ce cas, le dépôt de nickel est traité ultérieurement pour avoir une faible émissivité des rayons ultraviolet par le procédé chimique MAXORB^{mc}, procédé développé et possédé par INCO. L'assemblage conserve dans ce cas une excellente flexibilité et peut être utilisé pour éviter la détection dans des systèmes de vision de nuit. Il est aussi possible d'enduire l'endos du film de support pour une utilisation plus facile.

### EXEMPLE 3

Exemple semblable à l'exemple 1 dans lequel les conditions de l'étape électrochimique sont modifiées de façon à contrôler l'épaisseur et la conductivité locale du dépôt de nickel obtenu. Plus précisément la disposition, l'utilisation de cache et la distance entre les électrodes sont modifiées de façon à accroître localement les densités de courant. Sur un échantillon de 10 cm de largeur on peut ainsi faire varier la conductivité latérale du film de 0,3 à 0,01 ohm/carré. Une telle variante peut être utilisée pour optimiser pour les épaisseurs nécessaires dans les collecteurs de courant pouvant servir dans des générateurs électrochimiques. Des exemples du procédé et du dispositif obtenus sont montrés aux figures 10 et 11.

### EXEMPLE 4

Dans cet exemple, on démontre la possibilité d'utiliser un autre substrat métallisé que le cuivre pour obtenir le dépôt électrochimique de nickel. Une métallisation d'or est plaquée avec du cuivre puis avec du nickel de façon à obtenir une épaisseur métallique totale de 1 micron. Les dépôts électrochimiques de cuivre et de nickel sont sensiblement de même épaisseur dans ce cas. Une partie de l'échantillon est cependant traitée plus lentement (2 m/min vs 0,2 m/min) lors du dépôt du nickel de façon à illustrer la capacité de produire une épaisseur de nickel de 3 microns. Un des buts de cet exemple est d'illustrer la capacité du procédé de s'adapter à diverses applications pour autant que des métaux compatibles soient utilisés pour la métallisation et pour le dépôt électrochimique.

### EXEMPLE 5

Procédé semblable au procédé de l'exemple 1 dans lequel le plastique métallisé est utilisé comme résistance pour produire de la chaleur. Les chemins résistifs sont tracés par démétallisation mécanique ou par un assemblage de bandes de plastique métallisées. On montre aux figures 4 et 5 une vue en coupe et en plan d'un système de chauffe. Les principales parties sont la métallisation, le placage et son support sur lesquelles on a ajouté des contacts et optionnellement un revêtement isolant. La température maximale de fonctionnement en continu du système est fonction des matériaux utilisés. Elle peut être de l'ordre de 70°C pour le polypropylène, La puissance du système est reliée à la résistance entre les bornes pour un voltage donné.

Typiquement la résistance d'une surface carrée de feuillard métallique supporté sur plastique est de 0,15 ohm/carré avec un courant maximal permis de 500 mA/cm. Ainsi avec un feuillard métallique supporté sur plastique de dimension L=80 cm et 1-1 cm ou L représente longueur et 1 représente largeur auquel on applique, dans le sens de L, une tension de 6 volts, on obtient un courant total de 500 mA. La puissance dégagée par cet élément est de 3 watts. On peut donc obtenir une puissance de 375 watts/mètre carré si on utilise 125 bandes de feuillard métallique supporté sur plastique reliées en parallèle (voir figure 12). Dans le domaine résidentiel, on peut utiliser le feuillard métallique supporté sur plastique comme coupe-vapeur/élément chauffant (radiation d'infra-rouge long). Le fait d'alimenter le feuillard à une tension de 6 volts rend le système très sécuritaire comparativement aux systèmes de chauffage par infra-rouge long déjà existants qui fonctionnent à 120 volts. Dans le domaine de l'automobile on peut également utiliser le feuillard métallique supporté sur plastique comme élément de chauffage incorporé aux portières, sièges, plafonds, etc.

Le plastique métallisé et plaqué selon l'invention peut aussi être utilisé pour sa capacité à bloquer ou à réfléchir la lumière. Dans certains cas, l'utilisation d'un film métallique flexible est très désirable. Le film peut être utilisé dans les S'il est laminé entre deux plastiques, il ne sert qu'à bloquer la lumière. Laminé d'un seul côté, il peut servir de miroir pour donner un effet d'agrandissement de la pièce.

## Revendications

1. Procédé de préparation de feuillards métalliques constitués d'au moins un métal supporté par un film non-conducteur en résine synthétique comprenant les étapes suivantes:
- métallisation sous vide, d'au moins une face du film plastique de façon à obtenir un substrat comportant une surface métallique, ledit substrat étant suffisamment conducteur de l'électricité pour permettre un dépôt électrochimique uniforme,
- dépôt par placage électrochimique, d'au moins un métal sur la surface métallisée à partir d'une solution électrolytique, de façon à obtenir un film métallique mince ayant une épaisseur de métal comprise entre 0,1 et 4 microns, le substrat métallisé étant choisi de façon à être compatible et à faciliter l'étape de placage électrochimique, et le feuillard métallique mince obtenu étant adhérent et supporté sur ledit film plastique.

2. Procédé selon la revendication 1, caractérisé en ce que la métallisation sous vide s'effectue en continu.

3. Procédé selon la revendication 1 ou 2, caractérisé en ce que le dépôt par placage électrochimique s'effectue en continu.

4. Procédé selon la revendication 1, caractérisé par le fait que le procédé de métallisation sous vide est choisi parmi les procédés de vaporisation thermochimique simple, ou assisté.

5. Procédé selon la revendication 4, caractérisé en ce que la vaporisation thermochimique s'effectue par pulvérisation cathodique ou à faisceau d'électrons.

6. Procédé selon la revendication 1 ou 4, caractérisé en ce que l'on contrôle la surface métallisée par des procédés de cache ou de démétallisation.

7. Procédé selon la revendication 1 ou 4, caractérisé en ce que l'on contrôle la surface métallisée par des procédés de cache ou de démétallisation par faisceau laser, dissolution chimique, arrachement mécanique ou étincelage.

8. Procédé selon la revendication 1, caractérisé en ce que le film plastique non-conducteur isolant est en une résine synthétique choisie pour sa compatibilité avec le vide et les solutions associées avec les procédés de galvanoplastie.

9. Procédé selon la revendication 4, caractérisé en ce que la résine synthétique contient du polypropylène, un polyester, un polysulphone, un polyéthylène, ou un polyimide.

10. Procédé selon la revendication 1, caractérisé en ce que le substrat comportant une surface métallisée est constitué d'éléments compatibles avec le dépôt par placage électrochimique, choisi parmi les métaux suivants: Cu, Au, Ag, Fe, Ni, Cr, Zn, Mo ou leurs alliages.

11. Procédé selon la revendication 10, caractérisé en ce que la résistance de surface du substrat varie entre 0,1 et 10 ohm/carré.

12. Procédé selon la revendication 1, caractérisé en ce que le substrat métallisé est choisi parmi les métaux suivants: Cu, Au, Ag, ou leurs alliages dont la résistance de surface varie entre 0,1 et 14 ohm/carré.

13. Procédé selon la revendication 1, caractérisé en ce que la métallisation sous vide s'effectue de façon à ce que la surface métallisée ne couvre que partiellement la surface du film support isolant de façon à laisser des zones non-conductrices.

14. Procédé selon la revendication 13, caractérisé en ce que l'on obtient un recouvrement partiel de la surface du film par métallisation du film support isolant avant l'étape de dépôt électrochimique, par l'utilisation de masques lors de la métallisation, ou par ablation du dépôt métallisé.

15. Procédé selon la revendication 14, caractérisé en ce que l'ablation du dépôt métallisé s'effectue par traitement au laser, par étincelage, par voie chimique ou mécanique.

16. Procédé selon l'une quelconque des revendications 1, 2, 4, 5 et 8-12, caractérisé en ce que la surface métallisée est recouverte de masques isolants pour empêcher le placage localement, lesquels masques seront, le cas échéant, enlevés par la suite.

17. Procédé selon l'une quelconque des revendications 1, 2, 4, 5 et 8-12, caractérisé en ce que le métal déposé par placage est compris parmi les éléments suivants: Cu, Ni, Fe, Mo, Au, Ag, Cr, Zn, Pb, Cd ou leurs alliages.

18. Procédé selon l'une quelconque des revendications 1, 2, 4, 5 et 8-12, caractérisée en ce que le métal déposé par placage est compris parmi les éléments suivants: Ni, Fe, Au, Ag ou leurs alliages.

19. Procédé selon l'une quelconque des revendications 1, 2, 4, 5 et 8-12, caractérisé en ce que la métallisation s'effectue avec du cuivre et le métal du dépôt par placage comprend du nickel.

20. Procédé selon l'une quelconque des revendications 1, 2, 4, 5 et 8-12, caractérisé en ce que la solution électrolytique de placage est de type autocatalytique et que la métallisation utilisée est plus mince, que lorsqu'on utilise une solution électrolytique ordinaire.

21. Procédé selon l'une quelconque des revendications 1, 2, 4, 5 et 8-12, caractérisé en ce que l'on recouvre le feuillard métallique d'un film plastique.

22. Procédé selon l'une quelconque des revendications 1, 2, 4, 5 et 8-12, caractérisé en ce que l'on recouvre le feuillard métallique d'un film plastique par laminage ou collage.

23. Procédé selon l'une quelconque des revendications 1, 2, 4, 5 et 8-12, caractérisé en ce que l'on transfère le feuillard métallique en tout ou en partie, du support plastique vers une autre surface ayant une adhésion par rapport au dernier métal plaqué supérieur à celle entre la métallisation et le support plastique.

24. Procédé selon l'une quelconque des revendications 1, 2, 4, 5 et 8-12, caractérisé en ce que l'on traite le feuillard métallique chimiquement pour lui donner une faible émissivité dans l'ultraviolet.

25. Éléments chauffants qui peuvent être intégrés dans un ensemble flexible ou rigide, constitués de feuillards métalliques obtenus par un procédé selon l'une quelconque des revendications 1, 2, 4, 5 et 8-12.

26. Collecteurs de courant pour les batteries, constitués de feuillards métalliques obtenus par un procédé selon l'une quelconque des revendications 1, 2, 4, 5 et 8-12.

27. Collecteurs de courant pour les batteries au lithium à électrolyte polymère, constitués de feuillards métalliques obtenus par un procédé selon l'une quelconque des revendications 1, 2, 4, 5 et 8-12.

28. Film multicouche utilisé comme matériau d'emballage possédant une perméabilité très faible aux gaz et à l'humidité, constitués de feuillards métalliques obtenus par un procédé selon l'une quelconque des revendications 1, 2, 4, 5 et 8-12.

29. Ecrans pour la lumière, constitués de feuillards métalliques obtenus par un procédé selon l'une quelconque des revendications 1, 2, 4, 5 et 8-12.

30. Conducteurs flexibles, constitués de feuillards métalliques obtenus par un procédé selon l'une quelconque des revendications 1, 2, 4, 5 et 8-12.

31. Feuillard métallique comportant les éléments suivants:
- un film support isolant en résine synthétique;
- un dépôt métallisé obtenu par dépôt sous vide sur au moins une face du film support isolant, et sur la plus grande partie de ladite face pour laisser une bande non recouverte par ledit dépôt métallisé; sur un côté dudit film;
- un dépôt électrochimique d'épaisseur croissante depuis ladite bande jusqu'au côté opposé,
l'épaisseur moyenne de la somme du dépôt métallisé et du dépôt électrochimique étant comprise entre environ 0,1 et 4 microns.
